# EUROPEAN PATENT SPECIFICATION

(11) **EP 2 700 167 B1**
(45) Date of publication and mention of the grant of the patent: **15.12.2021**
(21) Application number: 12717553.7
(22) Date of filing: 19.04.2012
(51) Int. Cl.: G06F 15/78, H03K 19/17704

(54) **CONFIGURABLE LOGIC CELLS**
KONFIGURIERBARE LOGISCHE ZELLEN
CELLULES LOGIQUES CONFIGURABLES

(30) Priority: 21.04.2011 US 201161477754 P; 18.04.2012 US 201213449850
(43) Date of publication of application: 26.02.2014
(73) Proprietor: Microchip Technology Incorporated, Chandler, AZ 85224-6199 (US)
(72) Inventor: KILZER, Kevin, Lee, Chandler AZ 85225 (US); STEEDMAN, Sean, Phoenix AZ 85048 (US); ZDENEK, Jerrold, S., Riverside IL 60546 (US); DELPORT, Vivien, Chandler AZ 85249 (US); LUNDSTRUM, Zeke, Chandler AZ 85225 (US); DUVENHAGE, Fanie, Phoenix AZ 85045 (US)
(74) Representative: sgb europe
(86) International application number: PCT/US2012/034250
(87) International publication number: WO 2012/145511

(56) References cited:
- EP-A2- 0 306 962
- US-A- 6 020 757
- US-A1- 2003 062 922
- US-B1- 6 237 054
- US-B1- 6 803 785

## Description

This invention relates to configurable logic cells and, more particularly, to a RISC processor with combinatorial logic peripherals.

Most logic devices are available in a package with a single pin for each logic input and output (not counting power and ground pins). For example, a 74LS00 logic gate has four instances of a 2-input, 1-output device, requiring twelve pins, and is available in a fourteen pin package including power and ground.

In a system employing a number of configurable logic cells, it is often required that software reads the outputs of all cells at about the same time. Since the cells are instantiated independently, the output register (bit) for each cell is in a different register, and requires the central processing unit (CPU) to perform a number of read operations to determine the state of each bit. Inherently, this means that the cells are never sampled at the same time, and could in fact be samples at widely spaced intervals or perhaps in different orders, and this can at times produce misleading results.

Configurable logic cells of microcontrollers are versatile, but, having only a single logic function and/or state variable, can only be applied to a limited class of applications. FPGAs and PLDs provide configurable logic cells that are generally based on D flip-flop technology. While this is adequate for general purpose use and automated logic configuration, it does not always lead to a minimal circuit implementation solution.

US Patent US 6,803,785 discloses I/O circuitry shared between processor and programmable logic portions of an integrated circuit. United States Patent Application Publication US 2003/062922 discloses a programmable gate array having interconnecting logic to support embedded fixed logic circuitry. European Patent Application EP 0 306 962 discloses a single chip microprocessor. US 6 237 054 B1 discloses a microcontroller comprising a processor core and multiple configurable logic blocks (CLBs) coupled to the processor core.

These and other drawbacks in the prior art are overcome in large part by a system and method according to embodiments of the present invention.

An integrated circuit device, in accordance with embodiments as claimed includes a central processing core; and a plurality of peripherals operably coupled to the central processing core. In some embodiments, the plurality of peripherals include at least one configurable logic cell peripheral having more inputs/output connections than input-output connections on the integrated circuit device. In some embodiments, the inputs include one or more inputs from one or more integrated circuit subsystems.

In some embodiments, the inputs include at least one input from at least one other configurable logic peripheral. In some embodiments, the integrated circuit device includes a single microprocessor register configured for reading outputs of a plurality of configurable logic cells. In some embodiments, at least two of configurable logic cells are cascaded.

The present invention is defined in the appended independent claims to which reference should be made. Advantageous features are set out in the appended dependent claims.

The present invention may be better understood, and its numerous objects, features, and advantages made apparent to those skilled in the art by referencing the accompanying drawings. The use of the same reference symbols in different drawings indicates similar or identical items.
FIG. 1 illustrates an exemplary integrated circuit including a configurable logic cell.
FIG. 2 illustrates an exemplary data and address lines in an integrated circuit including a configurable logic cell.
FIG. 3 illustrates an exemplary module including a configurable logic cell.
FIG. 4A and FIG. 4B illustrate software control and configuration of a configurable logic cell.
FIG. 5A and FIG. 5B illustrate exemplary logic functions for a configurable logic cell that replaces two statically configured functions with a single, software-controlled function.
FIG. 6A - FIG. 6D illustrate logic function combinatorial options for an exemplary configurable logic cell.
FIG. 7A - 7D illustrate logic function state options for an exemplary configurable logic cell.
FIG. 8 illustrates an exemplary JK flip flop application and timing implemented with an exemplary configurable logic cell.
FIG. 9 is a diagram of an exemplary integrated circuit pin configuration.
FIG. 10 illustrates exemplary output register usage for a plurality of configurable logic cells.
FIG. 11 illustrates exemplary cascading of configurable logic cells.

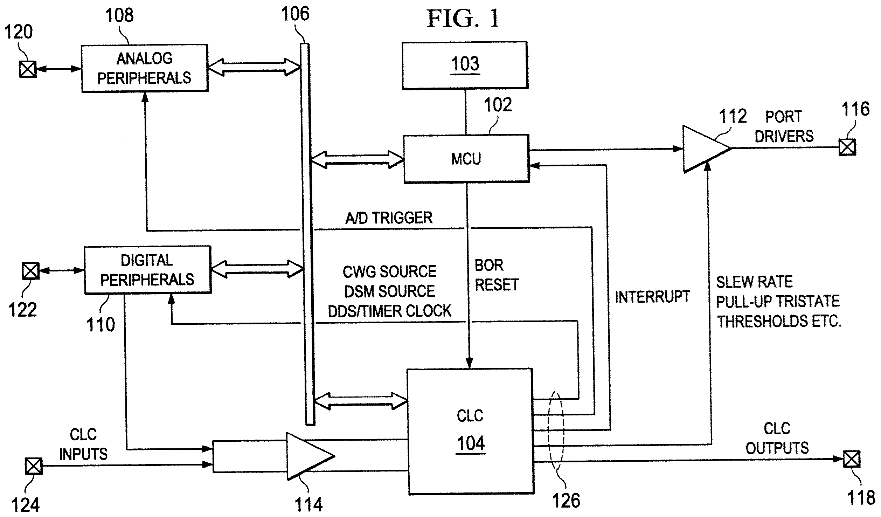

Turning now to the drawings and, with particular attention to FIG. 1, a diagram of a processor 100 according to an embodiment of the present invention is shown. The processor 100 includes a processor core (MCU) 102, which may be embodied as a RISC core. The processor core 102 couples via a bus 106 to one or more on-chip peripheral devices, such as analog peripherals 108 and digital peripherals 110.

In addition, as will be explained in greater detail below, the processor 100 further includes one or more configurable logic cells (CLC) 104, functioning as peripheral devices and coupled to the bus 106. That is, the configurable logic cells 104 are addressable like other peripheral devices and provide logic functions for the system. These can include, for example, AND, OR, XOR functions, and D, JK, and SR storage.

The processor 100 further includes one or more input and/or outputs 116, 118, 120, 122, 124, and associated port drivers, input controls 114, etc.

In the embodiment illustrated, the configurable logic cell 104 receives inputs from external pin 124, digital peripherals 110, and a reset from the processor core 102. These can include, for example, CWG source, DSM source, and DDS/Timer clock inputs. In general, inputs can come from I/O pins, register bits, other peripherals, and internal clocks.

In addition, the configurable logic cell 104 can provide digital outputs to one or more of the analog peripherals 108, the digital peripherals 110, and the processor core 102. Additional outputs (such as slew rate, pull-up tristate thresholds, etc.) can be provided to port drivers 112, while others can be provided to external pins 118.

Thus, in general, the configurable logic cell 104 can receive inputs from any subsystem such as a digital peripheral, I/O port, or internal status bits, or reset signals, including for example, oscillator output, system clocks, etc., and provides outputs to I/O pins, peripherals, a processor core interrupt, I/O port control functions, status signals, system clock, and even to other configurable logic cells (not shown).

As noted above, in some embodiments, the configurable logic cell 104 is addressed like other peripheral devices and may be configured at run-time. In some embodiments, the configurable logic cell 104 may be configured at run time using one or more special function registers (not shown). Thus, the configurable logic cell 104 is fully integrated into the processor address and data bus. Configuration can be applied statically or updated in real time based on the needs of the application.

In some embodiments, configuration of the configurable logic cell 104 can come from software registers or non-volatile memory. In some embodiments, the memory may be read and data transferred to configuration registers. In others, the memory may be statically connected for configuration (as in generic logic arrays/ programmable logic arrays (GAL/PAL)). Further, in some embodiments, after an initial configuration, software may update the configuration.

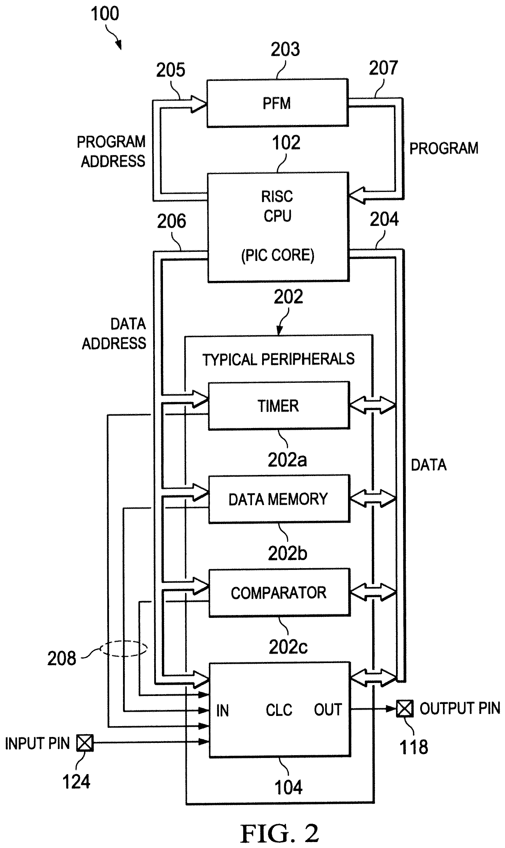

As such, in some embodiments, system signals and I/O signals are routed to the configurable logic cell 104, as shown in FIG. 2. The configurable logic cell 104 then performs the configured logic and provides an output. In particular, shown in FIG. 2 is processor 100 including processor core 102, a program flash memory 203, and peripherals 202. The program flash memory 203 couples via program address lines/bus 205 and program data lines/bus 207 to the processor core 102.

In the example illustrated, the peripherals include a timer 202a, data memory 202b, a comparator 202c, and the configurable logic cell 104. The peripherals couple to the processor core 102 by data address lines/bus 206 and data lines/bus 204. The configurable logic cell 104 may receive further individual inputs from the peripherals 208 or from an input pin 124. Thus, software and other peripherals can supply inputs to the configurable logic cell 104. The configurable logic cell 104 performs a configured logic operation and provides an output 312.

As noted above, the configurable logic cell implements one or more logic functions and can do so independently of the status of the processor core, e.g., while the processor core is in a sleep or debug mode.

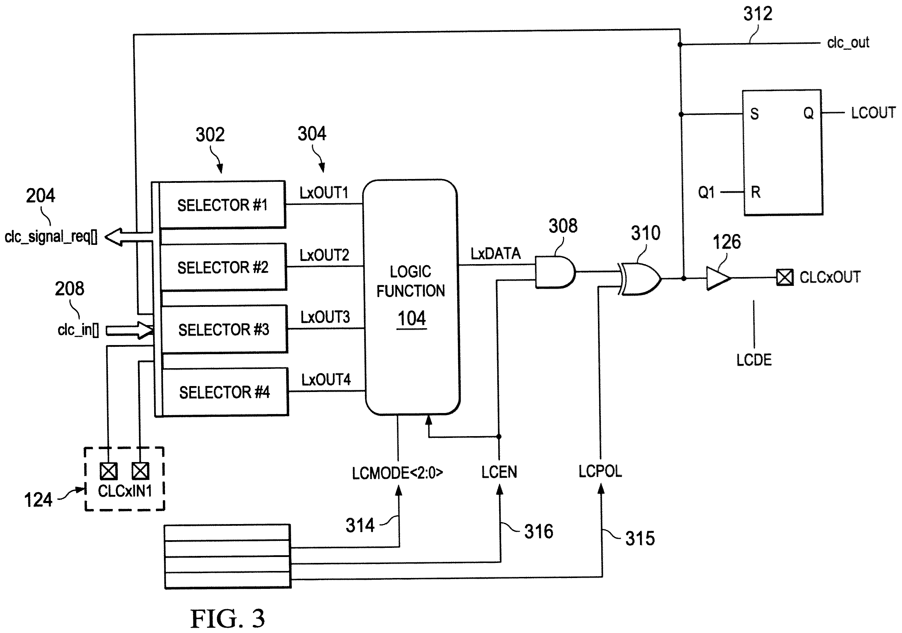

FIG. 3 illustrates the configurable logic cell environment according to one embodiment more particularly. Configurable logic cell 104 receives four channel inputs 304 LxOUT1, LxOUT2, LxOUT3, and LxOUT4 from a plurality of selectors 302. Inputs to the selectors 302 can come from signals 208 and I/O 124. In some embodiments, the selectors are multiplexers and/or configurable gates. For example, in some embodiments, the selectors 302 can reduce the number of input signals, for example inputs clc_in 208, for the logic cell 104 to four inputs 304 of the logic cell 104, to drive one of eight selectable single-output functions. Further details on particular implementations of the selectors 302 may be found in commonly-assigned patent application, titled "Selecting Four Signals from Sixteen Inputs," filed April 17, 2012.

According to the invention, the configurable logic cell 104 receives control inputs LCMODE<2:0> 314 and LCEN 316 from control registers (not shown). The output LxDATA of the configurable logic cell 104 is ANDed with the LCEN input 316. The output of AND gate 308 is XORed with LCPOL a control signal from a control register (not shown) and then output as CLCxOUT, all of which are explained in greater detail below.

As noted above, embodiments allow for real time configuration of the configurable logic cell. That is, configuration is provided through registers accessible from the microprocessor and can be updated based, for example, on external inputs, time of day, temperature of the system, coincidence with other events, or commands from a remotely controlling host.

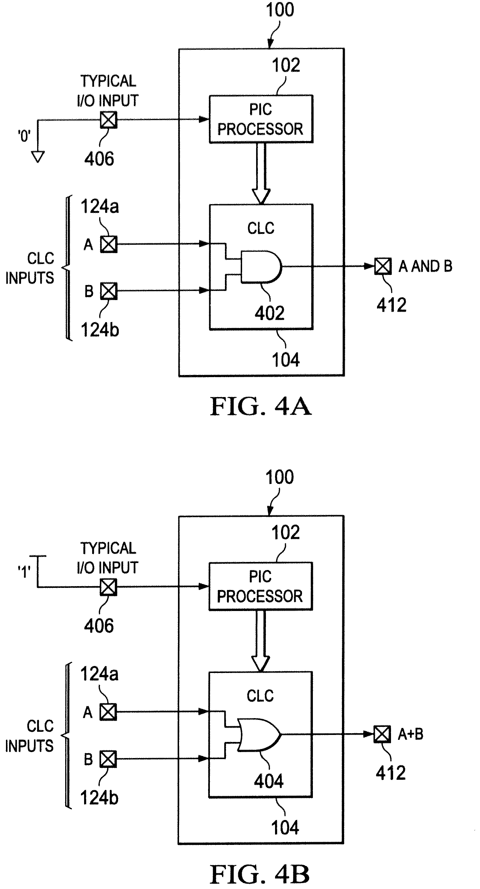

FIG. 4A and FIG. 4B schematically illustrate such operation. In particular, shown is processor 100 including processor core 102 and configurable logic cell 104. The processor 100 has an I/O input 406 to the processor core 102 and a pair of inputs 124a, 124b to the configurable logic core 104. The configurable logic cell 104 outputs to pin 412.

In operation, the state of the I/O pin 406 can be used to set the configurable logic core function. In the example illustrated, when the logic state of the I/O input 406 is "0", the processor core 102 writes to one or more registers (such as the LxMode register 314 of FIG. 3) to cause the configurable logic cell 104 to implement an AND function 402, so that the outputs on pin 412 is the logical AND of inputs A 124a and B 124b (AB). In contrast, when the logic state of the I/O input 406 is "1", the processor core 102 writes to one or more registers to cause the configurable logic cell 104 to implement an OR function 404, so that the output on pin 412 is the logical OR of inputs A 124a and B 124b (A+B). As can be appreciated, once the functions are set, the configurable logic cell 104 implements the configured function regardless of the functioning of the processor core 102.

Advantageously, the configurable logic cell 104 of embodiments of the present invention allows for dynamic configuration and direct access to software, allowing software to reconfigure individual gates and inverters while the system is running. That is, the configurable logic cell of embodiments of the invention allows real-time software access to internal configuration and signal paths, without requiring a microprocessor interface.

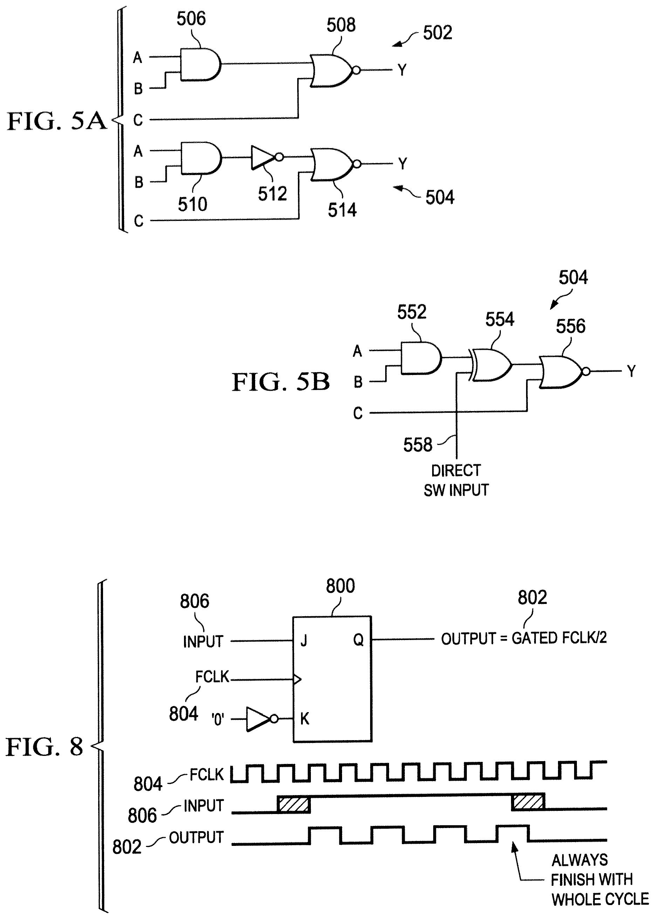

For example, as shown in FIG. 5A, a static configuration of a microprocessor interface for implementing the two functions ((A^{∗}B) + C)' and ((A^{∗}B)' + C)' requires two versions 502, 504, including AND gates 506, 510, NOR gates 508, 514, and inverter 512.

In contrast, an exemplary configurable logic cell 104 for implementing the functions is shown in FIG. 5B. The configurable logic cell 104 includes AND gate 552, XOR gate 554, and NOR gate 556. Inputs A and B are provided to AND gate 552, while input C is provided to the NOR gate 556. The output of the AND gate 552 is provided to the XOR gate 554, while the XOR gate 554 provides its output to the input of NOR gate 556. In addition, a direct software (SW) input 558 (e.g., from a control register) is provided to the input of the XOR gate 554. In this way, both functions of circuits 502, 504 are implemented using a single circuit and yet allowing direct software control.

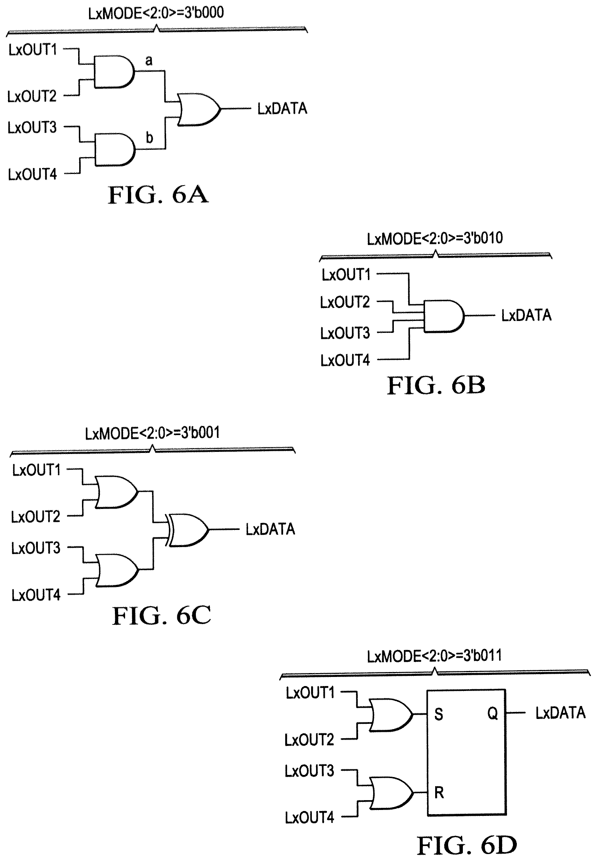

Exemplary combinatorial options for a particular four-input configurable logic cell are shown in FIG. 6A-6D. More particularly, in some embodiments, a LxMODE<2:0> configuration register 314 (FIG. 3) defines the logic mode of the cell. When LxMODE = 000, the configurable logic cell implements and AND-OR function. When LxMODE = 001, the cell implements an OR-XOR function. When LxMODE = 010, the cell implements an AND; when LxMODE = 011, the cell is an RS latch.

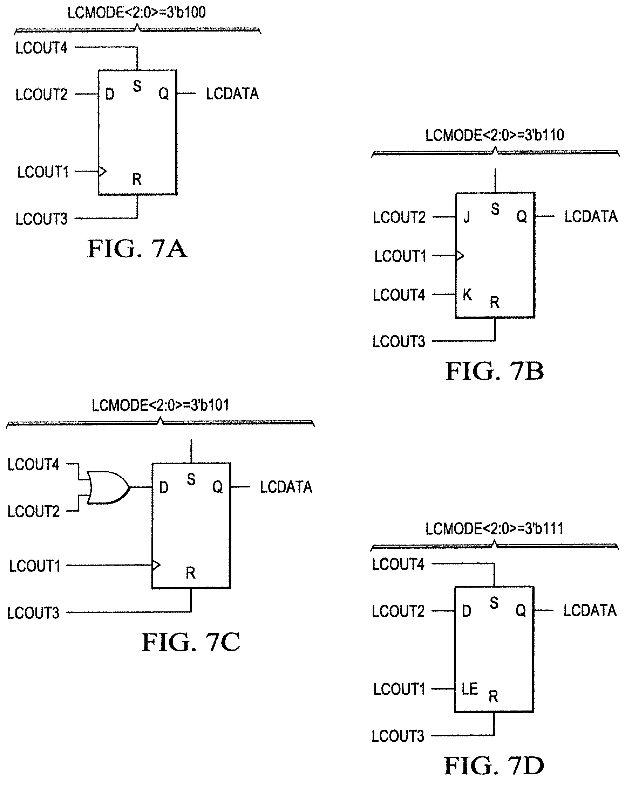

Correspondingly, the configurable logic cell 104 may incorporate a plurality of state logic functions. These are shown with reference to FIG. 7A-7D. The state functions include both D (FIG. 7A) and JK flipflops (FIG. 7B) with asynchronous set (S) and Reset (R). Input channel 1 (LCOUT1) provides a rising edge clock. If a falling edge is required, channel 1 (LCOUT1) can be inverted in the channel logic (not shown). Input channel 2 (LCOUT2), and sometimes channel 4 (LCOUT4), provide data to the register or latch inputs.

When LCMODE = 100, the cell implements a one input D flipflop with S and R. When LCMODE = 101, the cell implements a two input D flipflop with R. When LCMODE = 110, the cell implements a JK flipflop with R. When LCMODE = 111, the cell implements a one input transparent latch with S and R (The output Q follows D while LE is low and holds state while LE is high).

FIG. 8 illustrates an example operation of a JK flip-flop in accordance with embodiments of the invention. In particular, shown is a clock gating example including a JK flip flop 800, with input 806, output 802, and clock 804. The output 802 is a gated FCLK/2.

The JK flipflop can be configured according to FIG. 7B, with the clock at LCOUT1, J input at LCOUT2, and K input (inverted) at LCOUT4. As can be seen, the output 802 always includes a whole number of cycles. It is noted that other logic and state functions can be implemented. Thus, the figures are exemplary only.

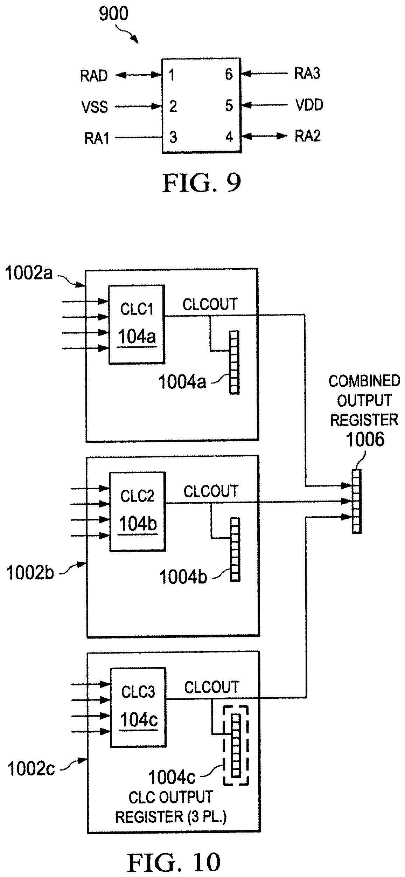

As noted above, each configurable logic cell 104 has four inputs selectable from a constellation of eight available signals, and one output, although other numbers of signals and inputs are possible. In some embodiments, however, the integrated circuit package includes only four input-output pins. That is, the integrated circuit package includes one pin for output and three for input. This is shown by way of example in FIG. 9, integrated circuit 900 includes pins RA0, RA1, RA2, RA3, Vss and Vdd. RA0-RA2 may be inputs, for example, and RA3 may be the output. Other inputs to the configurable logic cell 104 come from other peripherals on the internal data bus. In some embodiments, in which the integrated circuit includes more than one peripheral logic cell, inputs can come from other peripheral logic cells, as will be discussed in greater detail below.

More particularly, in implementations including more than one peripheral logic cell 104, it is desirable to be able to read multiple cell outputs substantially simultaneously. Consequently, in accordance with embodiments of the present invention, a combined output register may be provided. This is shown in FIG. 10, which illustrates three configurable logic units 1002a, 1002b, 1002c. It is noted that more or fewer than three may be provided. Thus, the figures are exemplary only.

Each configurable logic unit 1002a, 1002b, 1002c includes a configurable logic cell 104a, 104b, 104c, respectively. Each further includes an output CLCOUTA, CLCOUTB, CLCOUTC, respectively. In implementations in which only one configurable logic cell is employed, the output is provided to an associated output register 1004a, 1004b, 1004c, respectively.

However, when more than one configurable logic cell is in use, the outputs are provided to the common register 1006, outside the configurable logic unit instances. By providing the combined output register 1004 outside the instances of each of the logic units, their combined outputs may be read substantially simultaneously.

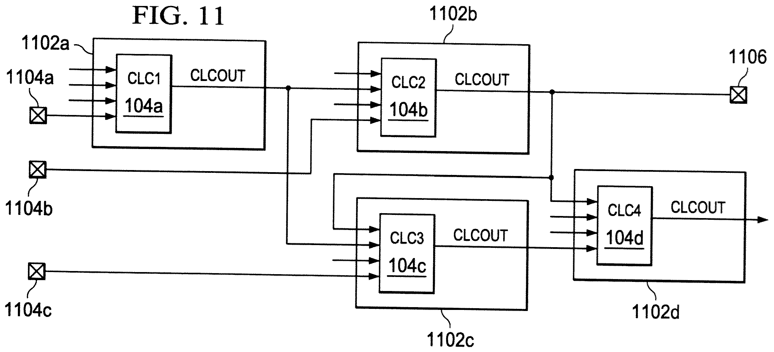

In addition, by providing multiple configurable logic cells having inputs other than external pins, the cells can be cascaded to create complex combinations. This is shown by way of example in FIG. 11.

In particular, shown in FIG. 11 is a system 1100 including a plurality of configurable logic units 1102a, 1102b, 1102c, 1102d, each including a corresponding configurable logic cell 104a, 104b, 104c, 104d, respectively. As shown, the configurable logic cell 104a provides its output to configurable logic cell 104b and 104c, while configurable logic cell 104b provides outputs to an external pin 1106 as well as to inputs of configurable logic cell 104c and configurable logic cell 104d. In addition, the configurable logic cell 104d provides its output to a output line, e.g., to another peripheral or to the processor core.

As can be seen each of the configurable logic cells 104a, 104b, 104c, 104d has four inputs and can receive input signals from input pins 1104a, 1104b, 1104c, from other configurable logic cells, or from other on-chip and peripheral devices.

While specific implementations and hardware/software configurations for the mobile computing device have been illustrated, it should be noted that other implementations and hardware configurations are possible and that no specific implementation or hardware/software configuration is needed. Thus, not all of the components illustrated may be needed for the mobile computing device implementing the methods disclosed herein.

As used herein, whether in the above description or the following claims, the terms "comprising," "including," "carrying," "having," "containing," "involving," and the like are to be understood to be open-ended, that is, to mean including but not limited to. Only the transitional phrases "consisting of" and "consisting essentially of," respectively, shall be considered exclusionary transitional phrases, as set forth, with respect to claims, in the United States Patent Office Manual of Patent Examining Procedures.

Any use of ordinal terms such as "first," "second," "third," etc., in the claims to modify a claim element does not by itself connote any priority, precedence, or order of one claim element over another, or the temporal order in which acts of a method are performed. Rather, unless specifically stated otherwise, such ordinal terms are used merely as labels to distinguish one claim element having a certain name from another element having a same name (but for use of the ordinal term).

## Claims

1. A microcontroller comprising a housing having a predetermined number of external pins (RA0; RA1, RA2, RA3, VSS, VDD), comprising:
a central processing core (102);a plurality of peripherals (104; 110) operably coupled to the central processing core, the plurality of peripherals including at least one digital peripheral (110) and at least one configurable logic cell peripheral (104; 1002; 1102), the at least one configurable logic cell peripheral (104; 1002; 1102) having n input/output connections including a plurality of inputs (304) and an output,
a plurality of selectors (302), each selector being associated with one of the inputs (304) of the at least one configurable logic cell peripheral (104; 1002; 1102), wherein the at least one configurable logic cell peripheral (104; 1002; 1102) is adapted to receive input signals through said selectors (302), wherein each input signal for the at least one configurable logic cell peripheral (104) can be selected at least from output signals of the digital peripheral (104; 110) and from a first external pin and wherein an output signal of the at least one configurable logic cell peripheral (104; 1002; 1102) is provided to a second external pin, wherein n is greater than a number of input-output connections of the microcontroller that are coupled with said external pins (RA0; RA1, RA2, RA3),wherein the at least one configurable logic cell peripheral (104; 1002; 1102) is configured through a plurality of special function registers of the microcontroller which are programmable by the central processing core (102), wherein the plurality of special function registers comprise first control bits (LCMODE) which define a configurable logic function and a second control bit (LCEN) which enables the logic output of the configurable logic cell peripheral (104; 1002; 1102).

2. The microcontroller in accordance with claim 1, comprising a plurality of configurable logic cell peripherals (104; 1002; 1102) and associated selectors (302).

3. The microcontroller in accordance with claim 1 or 2, said inputs (304) including at least one input from at least one other configurable logic cell peripheral (1102a, b, c, d).

4. The microcontroller in accordance with claim 2, further including a single microprocessor register (1006) configured for reading outputs of the plurality of configurable logic cell peripherals (1002a, b, c).

5. The microcontroller in accordance with claim 4, wherein the microcontroller is configurable such that at least two of the plurality of configurable logic cell peripherals (1102a, b; 1102a, c; 1102b, d; 1102c, d) are cascaded.

6. The microcontroller according to one of the preceding claims comprising four configurable logic cell peripherals (104; 1002; 1102).

7. The microcontroller according to one of the preceding claims, further comprising a third control bit (LCPOL) which controls a polarity of the output signal of the at least one configurable logic cell peripheral (104; 1002; 1102).

8. The microcontroller according to one of the preceding claims, wherein three bits (LCMODE<2:0>) are provided in the special function registers to define eight different logic functions.

9. The microcontroller according to one of the preceding claims, wherein the configurable logic function is programmable to perform one of a logic function, a flip-flop function and a combination of a logic function and a flip-flop function.

10. The microcontroller according to claim 9, wherein the flip-flop function can be selected from an SR-flip-flop, a D-flip-flop and a JK-flip-flop.

11. The microcontroller according to one of the preceding claims, wherein the at least one configurable logic cell peripheral (104) comprises four inputs A, B, C, D and the functionality of the at least one configurable logic cell peripheral (104) is selected from the group of:
(A AND B) OR (C AND D);
A AND B AND C AND D;
(A OR B) XOR (C OR D);
(A OR B) control the S input of an SR-flip-flop and (C OR D) control a respective R input;
D-flip-flop function;
JK-flip-flop function; and
D-flip-flop function wherein (A OR B) control the D-input.

12. The microcontroller in accordance with one of the preceding claims, wherein after initial configuration, the configuration of the at least one configurable logic cell peripheral (104) can be updated via software.

13. The microcontroller in accordance with one of the preceding claims, further comprising for each input signal for the at least one configurable logic cell peripheral (104) a multiplexer operable to select between a plurality of internal and external signals.

14. The microcontroller in accordance with one of the preceding claims, wherein a function of the at least one configurable logic cell peripheral (104; 1002; 1102) is configurable through a single register (LxMode).

15. The microcontroller in accordance with one of the preceding claims, wherein an output of the configurable logic cell peripheral (104) is operable to control a slew rate of an output driver (112) of a port of the microcontroller.

## Patentansprüche

1. Mikrocontroller mit einem Gehäuse mit einer vorgegebenen Anzahl externer Pins (RA0; RA1, RA2, RA3, VSS, VDD), der aufweist:
einen zentralen Verarbeitungskern (102); eine Vielzahl von Peripherien (104; 110), die operativ mit dem zentralen Verarbeitungskern gekoppelt sind, wobei die Vielzahl von Peripherien zumindest eine digitale Peripherie (110) und zumindest eine konfigurierbare Logikzellen-Peripherie (104; 1002; 1102) aufweist, wobei die zumindest eine konfigurierbare Logikzellen-Peripherie (104; 1002; 1102) n Eingangs-/Ausgangsverbindungen einschließlich einer Vielzahl von Eingängen (304) und einem Ausgang aufweist,
eine Vielzahl von Selektoren (302), wobei jeder Selektor einem der Eingänge (304) der zumindest einen konfigurierbaren Logikzellen-Peripherie (104; 1002; 1102) zugeordnet ist, wobei die zumindest eine konfigurierbare Logikzellen-Peripherie (104; 1002; 1102) geeignet ist, Eingangssignale durch die Selektoren (302) zu empfangen, wobei jedes Eingangssignal für die zumindest eine konfigurierbare Logikzellen-Peripherie (104) zumindest aus Ausgangssignalen der digitalen Peripherie (104; 110) und von einem ersten externen Pin ausgewählt werden kann und wobei ein Ausgangssignal der zumindest einen konfigurierbaren Logikzellen-Peripherie (104; 1002; 1102) an einen zweiten externen Pin bereitgestellt wird, wobei n größer ist als eine Anzahl von Eingangs-Ausgangs-Verbindungen des Mikrocontrollers, die mit den externen Pins (RA0; RA1, RA2, RA3) gekoppelt sind, wobei die zumindest eine konfigurierbare Peripherie (104; 1002; 1102) durch eine Vielzahl von Spezialfunktionsregistern des Mikrocontrollers konfiguriert wird, die durch den zentralen Verarbeitungskern (102) programmierbar sind, wobei die Vielzahl von Spezialfunktionsregistern erste Steuerbits (LCMODE) aufweist, die eine konfigurierbare Logikfunktion definieren, und ein zweites Steuerbit (LCEN), das den Logikausgang der konfigurierbaren Logikzellen-Peripherie (104; 1002; 1102) aktiviert.

2. Mikrocontroller gemäß Anspruch 1, der eine Vielzahl von konfigurierbaren Logikzellen-Peripherien (104; 1002; 1102) und zugehörigen Selektoren (302) aufweist.

3. Mikrocontroller gemäß Anspruch 1 oder 2, wobei die Eingänge (304) zumindest einen Eingang von zumindest einer anderen konfigurierbaren Logikzellen-Peripherie (1102a, b, c, d) aufweisen.

4. Mikrocontroller gemäß Anspruch 2, der weiterhin ein einzelnes Mikroprozessorregister (1006) aufweist, das zum Lesen von Ausgängen der Vielzahl von konfigurierbaren Logikzellen-Peripherien (1002a, b, c) konfiguriert ist.

5. Mikrocontroller gemäß Anspruch 4, wobei der Mikrocontroller so konfigurierbar ist, dass zumindest zwei der Vielzahl von konfigurierbaren Logikzellen-Peripherien (1102a, b; 1102a, c; 1102b, d; 1102c, d) kaskadiert sind.

6. Mikrocontroller gemäß einem der vorhergehenden Ansprüche, der vier konfigurierbare Logikzellenperipherie (104; 1002; 1102) aufweist.

7. Mikrocontroller gemäß einem der vorhergehenden Ansprüche, der weiterhin ein drittes Steuerbit (LCPOL) aufweist, das eine Polarität des Ausgangssignals der zumindest einen konfigurierbaren Logikzellenperipherie (104; 1002; 1102) steuert.

8. Mikrocontroller gemäß einem der vorhergehenden Ansprüche, **dadurch gekennzeichnet, dass** in den Sonderfunktionsregistern drei Bits (LCMODE<2:0>) zur Definition von acht verschiedenen Logikfunktionen vorgesehen sind.

9. Mikrocontroller gemäß einem der vorhergehenden Ansprüche, wobei die konfigurierbare Logikfunktion programmierbar ist, um eine Logikfunktion, eine Flip-Flop-Funktion oder eine Kombination einer Logikfunktion und einer Flip-Flop-Funktion auszuführen.

10. Mikrocontroller gemäß Anspruch 9, **dadurch gekennzeichnet, dass** die Flip-Flop-Funktion aus einem SR-Flip-Flop, einem D-Flip-Flop und einem JK-Flip-Flop wählbar ist.

11. Mikrocontroller gemäß einem der vorhergehenden Ansprüche, wobei die zumindest eine konfigurierbare Logikzellen-Peripherie (104) vier Eingänge A, B, C, D aufweist und die Funktionalität der zumindest einen konfigurierbaren Logikzellen-Peripherie (104) ausgewählt ist aus der Gruppe:
(A UND B) ODER (C UND D);
A UND B UND C UND D;
(A ODER B) XOR (C ODER D);
(A ODER B) den S-Eingang eines SR-Flip-Flops steuern und (C ODER D) einen jeweiligen R-Eingang steuern;
D-Flip-Flop-Funktion;
JK-Flip-Flop-Funktion; und
D-Flip-Flop-Funktion, wobei (A ODER B) den D-Eingang steuert.

12. Mikrocontroller gemäß einem der vorhergehenden Ansprüche, wobei nach der initialen Konfiguration die Konfiguration der zumindest einen konfigurierbaren Logikzellen-Peripherie (104) per Software aktualisierbar ist.

13. Mikrocontroller gemäß einem der vorhergehenden Ansprüche, der weiterhin für jedes Eingangssignal für die zumindest eine konfigurierbare Logikzellen-Peripherie (104) einen Multiplexer aufweist, der betreibbar ist, um zwischen mehreren internen und externen Signalen auszuwählen.

14. Mikrocontroller gemäß einem der vorhergehenden Ansprüche, wobei eine Funktion der zumindest einen konfigurierbaren Logikzellen-Peripherie (104; 1002; 1102) über ein einziges Register (LxMode) konfigurierbar ist.

15. Mikrocontroller gemäß einem der vorhergehenden Ansprüche, wobei ein Ausgang der konfigurierbaren Logikzellen-Peripherie (104) betreibbar ist, um eine Anstiegsgeschwindigkeit eines Ausgangstreibers (112) eines Ports des Mikrocontrollers zu steuern.

## Revendications

1. Microcontrôleur comprenant un logement ayant un nombre prédéterminé de broches externes (RA0 ; RA1, RA2, RA3, VSS, VDD), comprenant :
un cœur de processeur central (102) ; une pluralité de périphériques (104 ; 110) couplés de manière opérationnelle au cœur de processeur central, la pluralité de périphériques comprenant au moins un périphérique numérique (110) et au moins un périphérique à cellules logiques configurables (104 ; 1002 ; 1102), l'au moins un périphérique à cellules logiques configurables (104 ; 1002 ; 1102) ayant n connexions d'entrée/sortie comprenant une pluralité d'entrées (304) et une sortie,
une pluralité de sélecteurs (302), chaque sélecteur étant associé à une des entrées (304) de l'au moins un périphérique à cellules logiques configurables (104 ; 1002 ; 1102), dans lequel l'au moins un périphérique à cellules logiques configurables (104 ; 1002 ; 1102) est configuré pour recevoir des signaux d'entrée par l'intermédiaire desdits sélecteurs (302), dans lequel chaque signal d'entrée pour l'au moins un périphérique à cellules logiques configurables (104) peut être choisi au moins à partir de signaux de sortie du périphérique numérique (104; 110) et à partir d'une première broche externe et dans lequel un signal de sortie de l'au moins un périphérique à cellules logiques configurables (104; 1002; 1102) est fourni à une seconde broche externe, dans lequel n est supérieur à un nombre de connexions d'entrée/sortie du microcontrôleur qui sont couplées auxdites broches externes (RA0 ; RA1, RA2, RA3), dans lequel l'au moins un périphérique à cellules logiques configurables (104; 1002; 1102) est configuré par l'intermédiaire d'une pluralité de registres de fonctions spéciales du microcontrôleur qui sont programmables par le cœur de processeur central (102), dans lequel la pluralité de registres de fonctions spéciales comprennent des premiers bits de commande (LCMODE) qui définissent une fonction logique configurable et un deuxième bit de commande (LCEN) qui active la sortie logique du périphérique à cellules logiques configurables (104 ; 1002 ; 1102).

2. Microcontrôleur selon la revendication 1, comprenant une pluralité de périphériques à cellules logiques configurables (104; 1002; 1102) et de sélecteurs associés (302).

3. Microcontrôleur selon la revendication 1 ou 2, lesdites entrées (304) comprenant au moins une entrée d'au moins un autre périphérique à cellules logiques configurables (1102a, b, c, d).

4. Microcontrôleur selon la revendication 2, comprenant en outre un registre de microprocesseur unique (1006) configuré pour lire des sorties de la pluralité de périphériques à cellules logiques configurables (1002a, b, c).

5. Microcontrôleur selon la revendication 4, dans lequel le microcontrôleur est configurable de sorte qu'au moins deux parmi la pluralité de périphériques à cellules logiques configurables (1102a, b ; 1102a, c ; 1102b, d; 1102c, d) sont en cascade.

6. Microcontrôleur selon l'une des revendications précédentes, comprenant quatre périphériques à cellules logiques configurables (104 ; 1002 ; 1102).

7. Microcontrôleur selon l'une des revendications précédentes, comprenant en outre un troisième bit de commande (LCPOL) qui commande une polarité du signal de sortie de l'au moins un périphérique à cellules logiques configurables (104 ; 1002 ; 1102).

8. Microcontrôleur selon l'une des revendications précédentes, dans lequel trois bits (LCMODE<2:0>) sont fournis dans les registres de fonctions spéciales pour définir huit fonctions logiques différentes.

9. Microcontrôleur selon l'une des revendications précédentes, dans lequel la fonction logique configurable est programmable pour exécuter l'une parmi une fonction logique, une fonction bascule et une combinaison d'une fonction logique et d'une fonction bascule.

10. Microcontrôleur selon la revendication 9, dans lequel la fonction bascule peut être choisie parmi une bascule RS, une bascule D et une bascule JK.

11. Microcontrôleur selon l'une des revendications précédentes, dans lequel l'au moins un périphérique à cellules logiques configurables (104) comprend quatre entrées A, B, C, D et la fonctionnalité de l'au moins un périphérique à cellules logiques configurables (104) est choisie dans le groupe suivant :
(A ET B) OU (C ET D) ;
A ET B ET C ET D ;
(A OU B) OU exclusif (C OU D) ;
(A OU B) commande l'entrée S d'une bascule RS et (C OU D) commande une entrée R respective ;
fonction bascule D ;
fonction bascule JK ; et
fonction bascule D où (A OU B) commande l'entrée D.

12. Microcontrôleur selon l'une des revendications précédentes, dans lequel, après la configuration initiale, la configuration de l'au moins un périphérique à cellules logiques configurables (104) peut être mise à jour par l'intermédiaire d'un logiciel.

13. Microcontrôleur selon l'une des revendications précédentes, comprenant en outre, pour chaque signal d'entrée pour l'au moins un périphérique à cellules logiques configurables (104), un multiplexeur permettant de choisir parmi une pluralité de signaux internes et externes.

14. Microcontrôleur selon l'une des revendications précédentes, dans lequel une fonction de l'au moins un périphérique à cellules logiques configurables (104 ; 1002 ; 1102) est configurable par l'intermédiaire d'un registre unique (LxMode).

15. Microcontrôleur selon l'une des revendications précédentes, dans lequel une sortie du périphérique à cellules logiques configurables (104) permet de commander une vitesse de balayage d'un pilote de sortie (112) d'un port du microcontrôleur.
